# EUROPEAN PATENT APPLICATION

(11) **EP 4 645 375 A1**
(43) Date of publication of application: **05.11.2025**
(21) Application number: 24173370.8
(22) Date of filing: 30.04.2024
(51) Int. Cl.: H01L 21/67

(54) **A HEATER TRACK APPARATUS AND A SEMICONDUCTOR PACKAGE ASSEMBLY LINE INCORPORATING SUCH HEATER TRACK APPARATUS**

(71) Applicant: Nexperia B.V., 6534 AB Nijmegen (NL)
(72) Inventor: Miano, Seth, Hong Kong (HK); Uy, Marc Lester, Hong Kong (HK); Gabunada, Reil, Hong Kong (HK)
(74) Representative: Pjanovic, Ilija

(57) **Abstract**

A heater track apparatus and a semiconductor package assembly line comprising such heater track apparatus. The heater track apparatus is adapted to receive a reel-to-reel lead frame tape provided with an anti-tarnish layer. The heater track apparatus comprises a housing having a housing inlet and a housing outlet defining a process path line for the reel-to-reel lead frame tape, and a heating unit positioned within the housing next to the process path line structured to generate and emit heat towards the process path line.

## Description

### TECHNICAL FIELD

The present disclosure relates to the mass production of semiconductor packages. In particular the present disclosure relates to the use of a semi-endless reel-to-reel lead frame tape in a semiconductor package assembly line. More in particular, the present disclosure pertains to a heater track apparatus adapted to receive such (semi-endless) reel-to-reel lead frame tape provided with an anti-tarnish layer. The present disclosure also pertains to a semiconductor package assembly line comprising such heater track apparatus.

### BACKGROUND OF THE DISCLOSURE

Lead frames are metal structures used for semiconductor chip packaging and are processed on (semi-endless) reels of a significant length for large-scale production of semiconductor packages. To increase the shelf life against corrosion, these lead frame reels are coated with an organic anti-tarnish layer.

During the eutectic bonding process in the semiconductor package assembly line, the lead frame is generally exposed to heat and the organic anti-tarnish layer outgasses (evaporates and/or decomposes), and volatile byproducts are thus released from the anti-tarnish layer travelling through the various process stations of the semiconductor device assembly line. Because of condensation of the volatile byproducts on the cold parts of the process stations, the byproducts contaminate various sensitive components of the process stations (such as optics, sensors, etc.) leading to errors, downtime, reduction of efficiency of the assembly line, and in general to increased costs.

It is known to subject such semi-endless reel-to-reel lead frame tape in a pre-processing step to e.g. an alkaline cleaner or other types of chemicals, or to a plasma in order to remove the organic anti-tarnish layer prior to the eutectic bonding process in the semiconductor package assembly line. However, those cleaning techniques involve taking the reel-to-reel lead frame tape offline to perform the cleaning process, thereby hampering the high-speed processing and high throughput requirements of the semiconductor package assembly line.

Thus, it is a goal of the disclosure to provide an improved and inline apparatus for removing the anti-tarnish layer of a reel-to-reel lead frame tape without hampering the high-speed processing and high throughput requirements of the semiconductor package assembly line.

### SUMMARY OF THE DISCLOSURE

The disclosure pertains to a heater track apparatus structured to be accommodated in a reel-to-reel lead frame tape semiconductor package assembly line. The heater track apparatus is adapted to receive a reel-to-reel lead frame tape provided with an anti-tarnish layer. The heater track apparatus comprises a housing having a housing inlet and a housing outlet defining a process (transport) path line for the reel-to-reel lead frame tape, and a heating unit positioned within the housing next to the process path line structured to generate and emit heat towards the process path line.

The heater track apparatus has the benefit that it can clean the anti-tarnish layer off of a reel-to-reel lead frame tape, while being accommodated in a semiconductor package assembly line. In particular, the heater track apparatus removes the anti-tarnish layer off of the reel-to-reel lead frame tape whilst being transported or processed from the housing inlet through the housing towards and the housing inlet and subsequently towards the semiconductor package assembly line. Thereby a clean reel-to-reel lead frame tape is provided for the other process stations of the semiconductor package assembly line, which no longer causes contamination of sensitive components at those stations due to undesired release of the volatile byproducts of the heated anti-tarnish layer. The clean reel-to-reel lead frame tape can be processed without causing any malfunction or standstill and maintains the desired high-speed processing performance of the semiconductor assembly line.

To provide a clean reel-to-reel lead frame tape, a heating unit is used to generate and emit heat towards the process path along which the reel-to-reel lead frame travels in the heater track apparatus and, in more general, in the semiconductor package assembly line. In turn, the heat causes the anti-tarnish layer to vaporize and/or decompose into volatile byproducts. Cleaning the reel-to-reel lead frame tape this way reduces the downtime and increases the efficiency of the individual process stations, resulting in reduced overall costs. Additionally, since the anti-tarnish removal is performed inline, high throughputs of the assembly line can still be maintained also aiding towards the reduction of costs as compared to already known removal methods.

In other words, the lead frame tape is passed from one reel through the heater track apparatus, which heats up the lead frame resulting in vaporizing and/or decomposing of the anti-tarnish layer while it is moving through the housing towards the other reel for further processing in the semiconductor package assembly line. Thereby the heater track apparatus can be understood to output a lead frame tape, which has been cleaned from its anti-tarnish layer.

In an example of the heater track apparatus, the heating unit comprises a heating element, and in another example the heating element is configured as a ceramic heating element.

The heating element is needed to generate the required heat in the housing of the heater track apparatus for heating the reel-to-reel lead frame tape passing through. Additionally, when the heating element is configured as a ceramic heating element, it provides higher efficiency over other electric heating elements. Especially, since ceramic heating elements are well known to provide sufficient heat without heating the surrounding environment excessively.

According to another example of the disclosure, the heating unit further comprises an elongated thermally conductive heater track body positioned parallel to the process path line and positioned between the heating element and the process path line.

Having an elongated thermally conductive heater track body positioned between the heating element and the process path line allows the apparatus to distribute the heat evenly over a longer distance along the process path line, thus creating an improved heat exchanging effect with the reel-to-reel lead frame tape, while it is being transported along the process path line, such that the removal of the anti-tarnish layer can be expected to be even over the entire reel-to-reel lead frame tape.

In yet another example, the heating unit may further comprise a heater cover element positioned parallel to the process path positioned at an opposite location of the process path line with respect to the heating element.

The heater cover element allows for containing the heat generated in the heating unit close to the process path, such that most heat can go into heating the moving reel-to-reel lead frame tape instead of the atmosphere surrounding the heating unit. This ensures that less energy is wasted, and thus costs are saved, but also ensures that the heating of the reel-to-reel lead frame tape is performed in a more uniform manner.

In yet another example the heating unit is structured to generate heat in the housing to at least a temperature of 100 °C, but more preferably 200 °C, and even more preferably 300 °C.

The exact temperature needed for vaporization and/or decomposition of the anti-tarnish layer on a reel-to-reel lead frame depends on the material and the thickness of the anti-tarnish layer that are used. Typically, these materials can be understood to be organic materials, therefore only moderately high temperatures are needed to vaporize and/or decompose them.

Furthermore, the temperature as indicated in this example can be understood as the temperature of the reel-to-reel lead frame tape as is it passing through the heating unit, since the reel-to-reel lead frame tape would be needed to be heated to at least this temperature to vaporize and/or decompose its anti-tarnish layer.

In another example the heater track further comprises a filter unit structured - during use - to remove any volatile byproduct of the anti-tarnish layer from the housing.

Since the heating unit is generating heat and emitting it to the reel-to-reel lead frame tape, the anti-tarnish material on top of the reel-to-reel lead frame tape is evaporated and decomposed continuously as the reel-to-reel lead frame tape passes through the heater track apparatus, resulting in a continuous generation of volatile byproducts. In order to avoid condensation or deposition of the volatile byproducts on the just cleaned reel-to-reel lead frame tape as it is cooling down and moving out of the heater track apparatus, or on any other sensitive equipment close to the heater track apparatus, a filter unit is positioned inside the housing to remove any volatile byproduct of the anti-tarnish layer from the housing.

As an example, the filter unit may comprise a material mesh for capturing and containing the volatile byproducts. To further exemplify, this material mesh may even be made from a material chosen from a list but not limited to stainless steel, copper, Monel, non-stainless steel, titanium, PP, PE, PVC, PTFE, or FEP.

Having a material mesh as filter unit creates an enlarged surface area for the volatile byproducts to condensate onto, such that they are captured and contained from condensation elsewhere on unintended surfaces of the heater track apparatus. Furthermore, when the material is made of a thermally conductive material the volatile byproducts are more likely to condensate onto it, since the heat keeping the byproducts volatile is dissipated rapidly, thereby improving the condensation time.

In yet another example, the heater track apparatus further comprises an air flow generating unit structured to generate an airflow through the housing.

The air flow that is being generated by the air flow generating unit ensures that the heater track apparatus remains cool, especially in the parts where for example the filter unit is positioned. Furthermore, the air flow generating unit may induce an air flow in the housing, such that the volatile byproducts are driven or blown away from the reel-to-reel lead frame tape towards the filter unit.

To achieve the latter filtering effect more effectively the filter unit for example may be positioned in between the process path and the air flow generating unit, such that a draft towards the filter unit may be generated by a Venturi or Bernoulli principle.

In yet another example, the heater track apparatus may further comprise a carrier gas injection unit adapted to inject a carrier gas into the housing.

This carrier gas can have a twofold of benefits for the heater track apparatus. First, it may induce a flow for the volatile byproducts to move from the reel-to-reel lead frame tape to the filter unit. Alternatively, the influx of the carrier gas may not be enough to induce an adequate flow, but it could still overpressurize the housing such that a flow will be naturally generated towards the air flow generating unit by a Venturi or Bernoulli principle. Lastly, the carrier gas may also be chosen to be a gas which can dissolve the volatile byproducts in large quantities or drives the volatile contaminants away from the surfaces. This way, the volatile byproducts may be more effectively transported.

Another aspect of the disclosure is a semiconductor package assembly line, which is adapted to process a reel-to-reel lead frame tape, wherein the semiconductor package assembly line comprises a plurality of process stations defining an assembly line path having a main assembly line inlet and a main assembly line outlet for the reel-to-reel lead frame tape, and it further comprises at least one heater track apparatus according to the disclosure. In an example thereof, the housing outlet of the heater track apparatus may be in communication with the main assembly line inlet of the semiconductor package assembly line.

Implementing the heater track apparatus with any of the functionalities as described above has the benefit that it can remove the anti-tarnish layer of a reel-to-reel lead frame tape as is it moving through the semiconductor package assembly line and more specifically as it is moving through the heater track apparatus.

This way a clean reel-to-reel lead frame tape is outputted and can be utilized in any other process stations of the semiconductor package assembly line without causing errors due to contamination with volatile byproducts of the anti-tarnish layer that would otherwise arise upon processing of the reel-to-reel lead frame tape. Especially, when the heater track apparatus is the first process station of the semiconductor package assembly line.

This assembly line would therefore have reduced downtime and increased efficiency compared to alternative semiconductor package assembly lines utilizing already known removal methods or apparatuses. Additionally, it would still maintain high throughput of the semiconductor package assembly line. Furthermore, the exposed reel-to-reel lead frame tape would only be exposed to corrosive atmosphere for a short amount of time, because the heater track apparatus is employed inline and since the reel-to-reel lead frame tape would be moving fast after anti-tarnish layer removal along the assembly line path through the semiconductor package assembly line to the next processing station.

### BRIEF DESCRIPTION OF THE DRAWINGS

The disclosure will now be discussed with reference to the drawings.
Figure 1 shows a prior art semiconductor package assembly line.
Figure 2 and Figure 3 show examples of a semiconductor package assembly line according to the disclosure.
Figure 4 shows an example of a heater track apparatus according to the disclosure integrated in a semiconductor package assembly line.
Figure 5 shows the example of the heater track apparatus with a housing, shown in an open condition for clarifying purposes.
Figure 6 shows a schematic of the heating unit of the heater track apparatus.
Figure 7 shows a schematic of the filter unit and the air flow unit of the heater track apparatus.
Figure 8 shows a side view of the example of the heater track apparatus.

### DETAILED DESCRIPTION OF THE DISCLOSURE

For a proper understanding of the disclosure, in the detailed description below corresponding elements or parts of the disclosure will be denoted with identical reference numerals in the drawings.

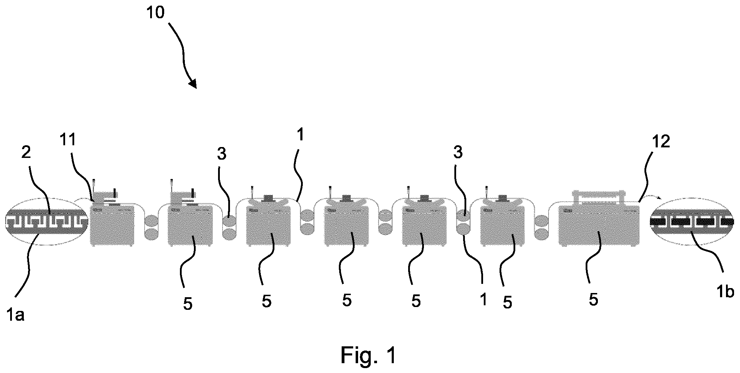

Figure 1 shows a semiconductor package assembly line 10 known in the art. Such a semiconductor assembly line 10 is adapted to receive and process a reel-to-reel lead frame tape 1 in various process stations 5. The reel-to-reel lead frame tape 1 is guided by reel rollers 3 between the various process stations 5. The various process stations 5 are depicted in a more or less identical manner, yet each process station 5 may perform a different process step on the reel-to-reel lead frame tape 1 upon its passing through the respective station.

The reel-to-reel lead frame tape is inserted at the semiconductor package assembly line inlet 11 following the assembly line path through the various process stations 5 to be outputted at the semiconductor package assembly line outlet 12. The reel-to-reel lead frame tape 1 enters the semiconductor package assembly line inlet 11 in an unprocessed state 1a and - after having traveled through the entire semiconductor assembly line 10 whilst undergoing various process actions at the process station 5 - leaves the semiconductor package assembly line outlet 12 in a processed state 1b. A processed lead frame tape 1b can be understood to comprise almost ready semiconductor packages, which only need to be punched out or singulated and whereof the lead terminals potentially need to be bend.

These types of semiconductor package assembly lines 10 are known to be inefficient, due to unwanted outgassing (evaporation and/or decompositions) of an anti-tarnish layer 2 of the reel-to-reel lead frame tape 1 from the heat generated during the eutectic bonding process in one of multiple of the process stations 5 of the semiconductor package assembly line 10. The anti-tarnish layer is denoted with reference numeral 2 in Figure 1 and is indicated as a (darker tinted) layer present on the unprocessed reel-to-reel lead frame tape 1a.

The outgassing of the anti-tarnish layer 2 during the passage or transport of the reel-to-reel lead frame tape 1 through the various process stations 5 leads to the generation of unwanted volatile byproducts from the organic anti-tarnish layer 2. These volatile byproducts likewise travel or propagate through the various process stations 5 and condensate or deposit on the cold parts of the process stations 5. This deposits contaminate various sensitive components of the process stations 5 (such as optics, sensors, etc.) leading to errors, downtime, and in general to increased costs, thereby making the semiconductor package assembly line 10 inefficient.

The assembly line personnel have therefore explored the pre-processing of the reel of lead frame tape 1 with chemical or plasma means before setting up the reel in the semiconductor package assembly line 10. Even though this process reduces the downtime of the process stations 5, it is still an inefficient process in the overall assembly process since the semiconductor package assembly line 10 cannot be operated continuously, while the reel is being pre-processed. Thus this precleaning process is taking too much time.

Moreover, pre-processing the reel of lead frame tape 1 leads to longer exposure of the lead frame tape 1 to corrosive oxygen in the air, degenerating the lead frame and thereby reducing the quality and/or yield of the manufactured semiconductor packages.

Therefore, this disclosure proposes a heater track apparatus 1000 and a semiconductor package assembly line 100₁-100₂, comprising such heater track apparatus 1000, which can effectively remove the anti-tarnish layer 2 of a reel-to-reel lead frame tape 1 during the processing thereof.

The heater track apparatus 1000 will be discussed in more detail later in this disclosure, but in essence a reel-to-reel lead frame tape 1 comprising an anti-tarnish layer 2 is passed from one reel through the heater track apparatus 1000, which heats up the lead frame 1 resulting in vaporizing and/or decomposing the anti-tarnish layer 2 while the lead frame tape 1 is moving through the heater track apparatus 1000, to the other reel for further processing in a process station 5 of the semiconductor package assembly line 100₁-100₂. This way, the heater track apparatus 1000 outputs a lead frame tape 1, which has been cleaned from its anti-tarnish layer 2.

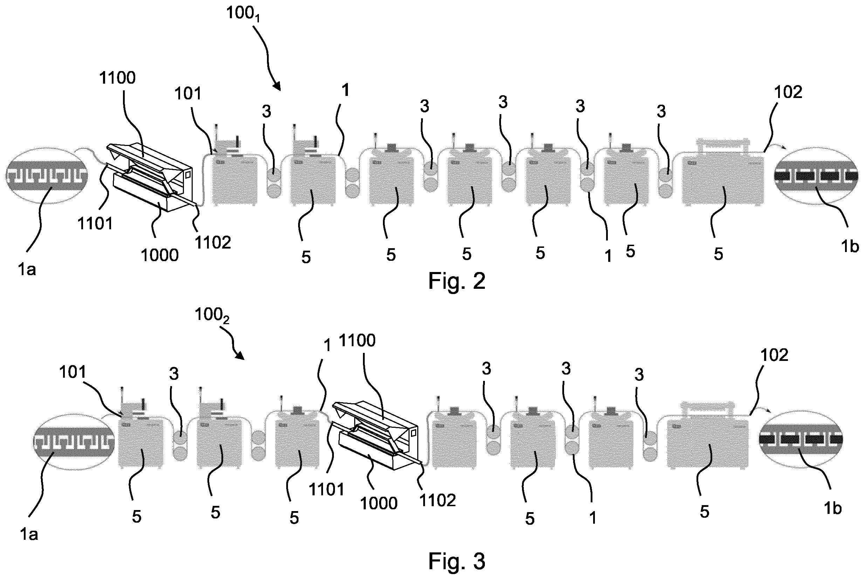

Figure 2 and Figure 3 show an example of such semiconductor package assembly line 100₁-100₂, which implements the removal the anti-tarnish layer 2 off of a reel-to-reel lead frame tape 1 by utilizing a heater track apparatus 1000, disclosed later on, before guiding the reel-to-reel lead frame tape 1 into the next process station 5 of the semiconductor package assembly line 100₁-100₂, thereby reducing the generation of volatile byproducts of the anti-tarnish layer 2 and the condensation or depositing of the unwanted volatile byproducts in subsequent process stations 5. This implementation reduces costs and downtime, while maintaining efficiency and throughput.

In Figure 2 a first example of the semiconductor package assembly line 100, is shown, wherein the heater track apparatus 1000 for removing the anti-tarnish layer 2 from the reel-to-reel lead frame tape 1 is the first station of the entire semiconductor package assembly line 100₁. In this example it is ensured that no unwanted volatile byproducts can condensate on any of the process stations 5 of the semiconductor package assembly line 100, downstream of the heater track apparatus 1000. In this example of Figure 2 the housing outlet 1102 of the heater track apparatus 1000 communicates with the main assembly line inlet 101 of the semiconductor package assembly line 100₁.

As seen in Figure 2, the reel-to-reel lead frame tape 1 is now introduced at the housing inlet 1101 of the heater track apparatus 1000 with the anti-tarnish layer 2, hence in the unprocessed state 1a and leaves the housing outlet 1102 without the anti-tarnish layer 2. The lead frame tape 1 is following the assembly line path through the various process stations 5 until the reel-to-reel lead frame tape 1 is outputted at the semiconductor package assembly line outlet 102 in its processed state 1b.

In the example of Figure 3, the semiconductor package assembly line inlet 101 is used to insert the reel-to-reel lead frame tape 1 with the anti-tarnish layer 2, thus in the unprocessed state 1a, much like in Figure 1. As shown in the example of Figure 3, the semiconductor package assembly line 100₂ may comprise the heater track apparatus 1000 being accommodated along the assembly line process, but not as the first station of the semiconductor package assembly line 100₂ as in Figure 2. In this example, a shortest exposure time possible is achieved for the reel-to-reel lead frame tape 1. This implementation can be used for critical semiconductor packages and processes wherein the first few process stations 5 of the semiconductor package assembly line 100₂ upstream from the heater track apparatus 1000 only comprise or execute processing steps performed at cold (room temperature) temperatures. In this example both the housing inlet 1101 and the housing outlet 1102 are communicating with two different process stations 5 (one upstream and one downstream), respectively.

In general, these assembly lines 100₁-100₂ would therefore have reduced downtime and increased efficiency compared to alternative semiconductor package assembly lines 10 utilizing already known removal methods or apparatuses. Additionally, it would still maintain high throughput of the semiconductor package assembly line 100₁-100₂. Furthermore, the exposed reel-to-reel lead frame tape 1 would only be exposed to corrosive atmosphere conditions for a short amount of time, since it would be moving at a fast processing speed through the semiconductor package assembly line 100₁-100₂ along the assembly line path to the next processing station 5.

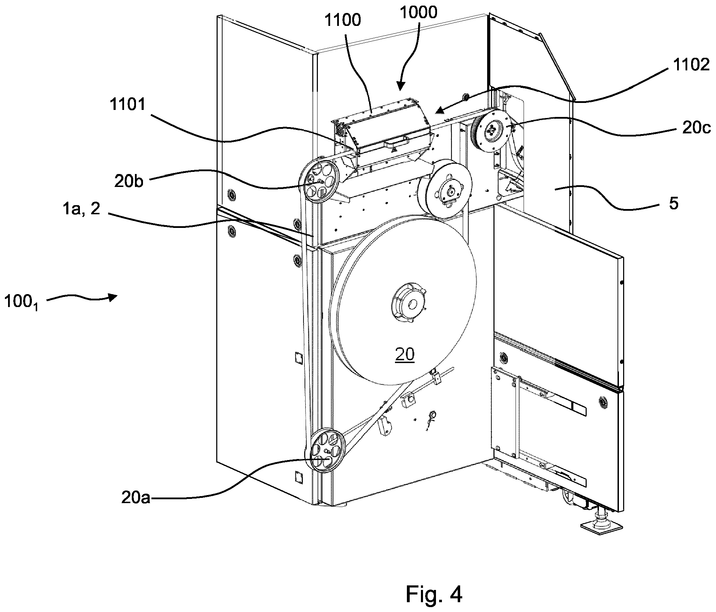

In Figure 4 a detailed view of the heater track apparatus 1000 employed in a semiconductor package assembly line 100₁ is shown. Note, that in this particular example the heater track apparatus 1000 is provided or mounted in a small space near or at the inlet of an already existing process station 5. Thus, the heater track apparatus 1000 for anti-tarnish removal can be utilized at or in already existing infrastructure, has a small formfactor and footprint, and can be used inline of the semiconductor package assembly line 100₁-100₂. Thereby a clean reel-to-reel lead frame tape 1 can be provided for the other process stations 5 of the semiconductor package assembly line 100₁-100₂. This in turn reduces the chances of contamination of sensitive components due to the undesired release of the volatile byproducts of the heated anti-tarnish layer 2.

In Figure 4, the reel-to-reel lead frame tape 1 (in its unprocessed state 1a and provided with an anti-tarnish layer 2) is supplied to the semiconductor package assembly line 100₁-100₂ on a supply roller 20. The reel-to-reel lead frame tape 1 with the anti-tarnish layer 2 is feed via supply rollers 20a-20b to the housing inlet 1101 of the heater track apparatus 1000. In the housing 1100 the lead frame 1 is heated such that the anti-tarnish layer 2 decomposes from the lead frame 1, The reel-to-reel lead frame 1 exits the housing outlet 1102 without the anti-tarnish layer 2 and is guided via the supply roller 20c in downstream process direction into the first process station 5 of the semiconductor package assembly line 100₁-100₂. The lead frame tape 1 is following the assembly line path through the various process stations 5 until the reel-to-reel lead frame tape 1 is outputted at the semiconductor package assembly line outlet 102 in its processed state 1b, see Figures 2 and 3.

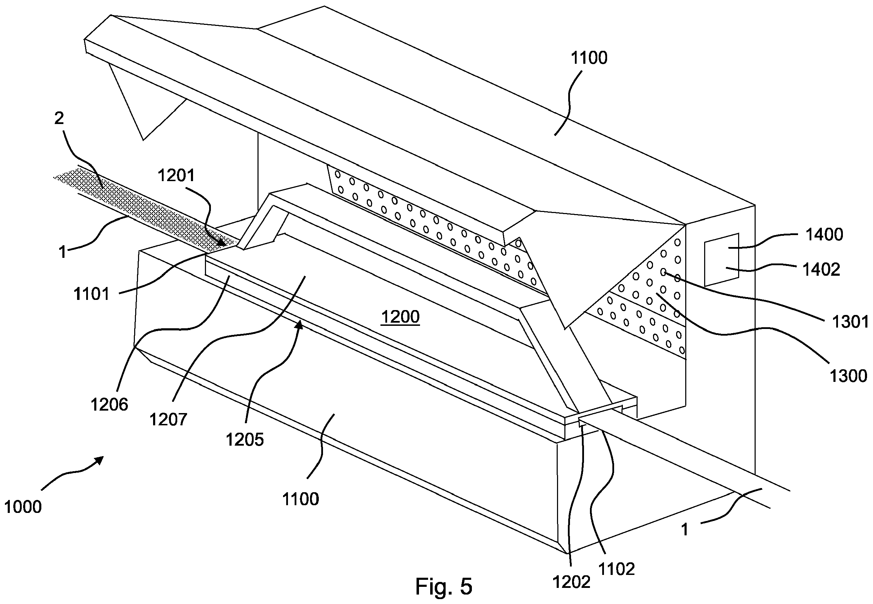

Further details on the heater track apparatus 1000 will be disclosed in Figure 5. The exploded view of the heater track apparatus 1000 shows in detail that the apparatus 1000 is adapted to receive a reel-to-reel lead frame tape 1 with an anti-tarnish layer 2, which is structured to be accommodated in a semiconductor package assembly line 100₁-100₂ as were already exemplified in the Figure 1-4.

The heater track apparatus 1000 is adapted to receive a reel-to-reel lead frame tape 1 provided with an anti-tarnish layer 2, denoted schematically as a grey layer covering the lead frame tape 1. The heater track apparatus 1000 comprises a housing 1100 having a housing inlet 1101 and a housing outlet 1102, which define a process or transport path line for the reel-to-reel lead frame tape 1 through the housing 1100. Reference numeral 1200 denotes a heating unit 1200 positioned within the housing 1100 next to the process path line. The heating unit 1200 is structured to generate and emit heat towards the process path line.

In the example of Figure 5, the heating unit 1200 also comprises a heating element 1205, which is configured as a ceramic heating element. It further comprises an elongated thermally conductive heater track body 1206 positioned parallel to the process path line and positioned between the heating element 1205 and the process path line, and it comprises a heater cover element 1207 positioned parallel to the process path positioned at an opposite location of the process path line with respect to the heating element 1205.

In this configuration the heating element 1200 can generate the required heat in the housing 1100 of the heater track apparatus 1000 for heating the reel-to-reel lead frame tape 1 passing through the housing 1100. Such lead frame tape 1 would be passed into the housing inlet 1101 into the heating unit inlet 1201, moving along the process path line where the anti-tarnish layer 2 is being removed through heating, and subsequently moved out of the heating unit outlet 1202 and out of the housing outlet 1102. This way, in generic terms, a reel-to-reel lead frame tape 1 comprising an anti-tarnish layer 2, would be fed into the heater track apparatus 1000 and a cleaned lead frame tape 1 would be outputted downstream towards a process station 5 of the semiconductor package assembly line 100₁-100₂, as depicted in Figures 2 or 3 (and 4).

The heating unit 1200 comprising a ceramic heating element provides higher efficiency over other electric heating elements. Furthermore, the heating efficiency is increased by the elongated heater track body 1206, since this would distribute the heat evenly over a longer distance along the process path line, thereby improving the heat exchange with the reel-to-reel lead frame tape 1, that is continuously being transported along the process path line. Lastly, the presence of a heater cover element 1207 allows for containing the heat generated in the heating unit 1200 close to the process path, aiding to the overall efficiency of the heating unit 1200 and in an efficient removal of the anti-tarnish layer 2.

With such a heating unit 1200 in the heater track apparatus 1000, the removal of the anti-tarnish layer 2 can be expected to be even and uniform over the entire reel-to-reel lead frame tape 1. Additionally, the removal can be expected to occur effectively, since most heat will go into heating the moving reel-to-reel lead frame tape 1 instead of the atmosphere surrounding the heating unit 1200 thanks to both the elongated heater track body 1206 and the cover element 1207. Hereby, less energy is wasted, and more costs are saved.

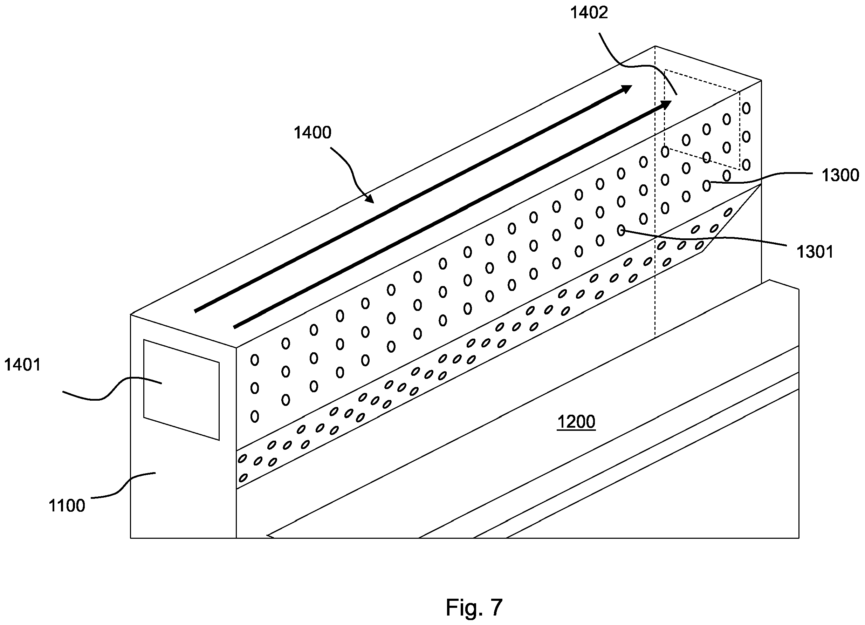

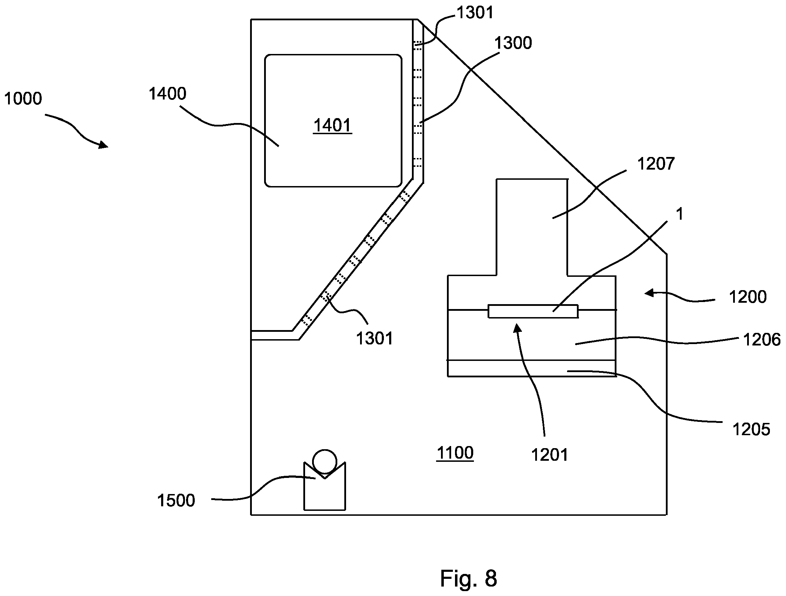

The heater track apparatus 1000 in Figure 5 further comprises a filter unit 1300 structured - during use - to remove any volatile byproduct of the anti-tarnish layer 2 from the housing 1100 and an air flow generating unit 1400 structured to generate an airflow through the housing 1100. These latter two units will be discussed in more detail in Figure 7 and Figure 8, respectively.

Still, some features of these units are depicted in Figure 5 and will thus be highlighted. For instance, the filter unit openings 1301 are shown in the example of Figure 5, through which the volatile byproducts are passed and subsequently condensate in, such that they are captured and contained. Moreover, the air flow generating unit outlet 1402 of the air flow generating unit 1400, as exemplified in Figure 5, has such orientation that the air flow that is being generated is parallel to the process path, which will create a draft from inside the housing through the filter unit openings 1301, and which ensures a cool temperature of the filter unit 1300, such that condensation of the unwanted byproducts will most likely occur.

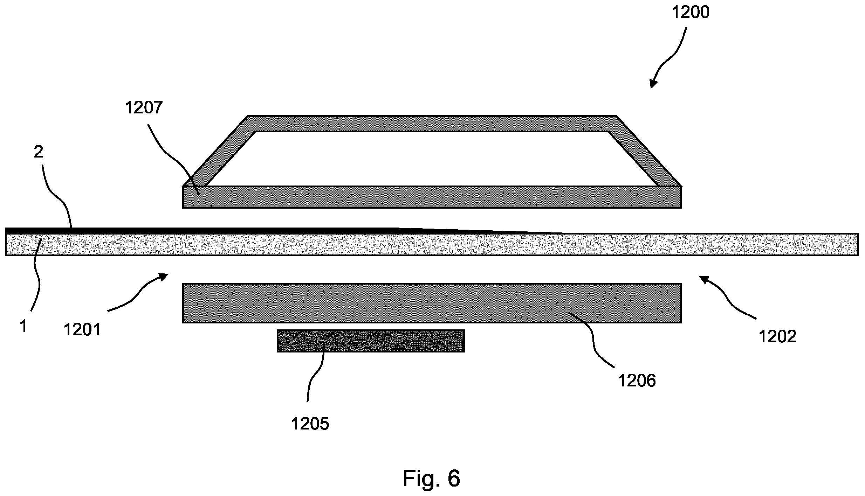

Next in Figure 6 a schematic side view of the heating unit 1200 of Figure 5 is shown. This heating unit 1200 provides a clean reel-to-reel lead frame tape 1, by generating and emitting heat towards the process path along which the reel-to-reel lead frame tape 1 travels on in heater track apparatus 1000. The provided heat causes the anti-tarnish layer 2 to vaporize and/or decompose into volatile byproducts, cleaning the reel-to-reel lead frame tape 1.

Similarly, the exemplary heating unit 1200 in Figure 6 comprises a heating element 1205, which is configured as a ceramic heating element. In this figure, it is shown on the bottom of the process path line on which the lead frame tape 1 travels.

The heating unit 1200 further comprises an elongated thermally conductive heater track body 1206 positioned parallel to the process path line and positioned between the heating element 1205 and the process path line. This is shown in the figure having some distance between the heating element, which may or may not be necessary dependent on the type of application of the heating unit 1200. Alternatively, the elongated heater track body 1206 may even be adjacent to the heating element 1205 and thermally connected by for example thermal paste, such that an even greater heat transmission can be achieved between the heating element 1205 and the thermally conductive heater track body 1206.

The heating unit 1200 in Figure 6 further comprises a heater cover element 1207 positioned parallel to the process path positioned at an opposite location of the process path line with respect to the heating element 1205, which contains the heat close to the process path line, such that optimal heating of the lead frame tape 1 can be achieved.

As shown in Figure 6 the lead frame tape 1 enters the heating unit 1200 at the heating unit inlet 1201 with an anti-tarnish layer 2 covering the lead frame tape 1. Inside the heating unit 1200 the lead frame tape 1 is heated to at least a temperature of 100 °C, but more preferably 200 °C, and even more preferably 300 °C to vaporize and/or decompose the anti-tarnish layer 2. Thereafter the lead frame tape 1 moves out of the heating unit 1200 cleaned from its anti-tarnish layer.

It may be understood in general that the heating unit 1200 is generating the above-mentioned desired temperatures, because the anti-tarnish layer 2 typically comprises organic materials. Therefore, only moderately high temperatures are needed to vaporize and/or decompose them. The exact temperature needed for vaporization and/or decomposition in the end depends on the exact material and the thickness of said anti-tarnish layer 2. After vaporization and/or decomposition volatile byproducts are formed, which flow out of the heating unit 1200.

As is further shown in the side view of Figure 6 both the elongated heater track body 1206 and the cover element 1207 are positioned at a distance from the process path line. As the reel-to-reel lead frame tape 1 is moving at a high speed through the housing 1100 and the heating unit 1200 the distance thus created between the elements 1206/1207 of the heating unit 1200 and the lead frame tape 1 will prevent any drag, rub, and potentially rupture of the lead frame tape 1.

The distances for both elements 1206/1207 do not need to be the same. More in particular the exact distances again depend on the exact requirements of the heating unit 1200 for a specific anti-tarnish layer 2 of a reel-to-reel lead frame tape 1.

Figure 6 shows that the heater cover element 1207 may comprise a handle, which can be beneficial for holding and manipulating either the heater cover element 1207 and/or the entire heating unit 1200, when setting up the reel-to-reel lead frame tape 1 in the semiconductor package assembly line 100₁-100₂.

In Figure 7 an enlarged view an example of a filter unit 1300 and an air flow generating unit 1400 of a heater track apparatus 1000 with open housing 1100 for viewability according to the disclosure are shown.

The filter unit 1300 will be discussed first, which is structured - during use - to remove any volatile byproduct of the anti-tarnish layer 2 from the housing 1100. Because of the continuous generation of unwanted volatile byproducts and thus because of a continuous potential chance of condensation on the just cleaned reel-to-reel lead frame tape 1 as it is cooling down and moving out of the heater track apparatus 1000, it would be beneficial to remove and contain the unwanted volatile byproducts inside a filter unit 1300.

To do so, the filter unit 1300 is positioned inside the housing 1100, as shown in Figure 7 and in the cross section of Figure 8. Further according to the example of Figure 7, the filter unit 1300 may comprise a plurality of filter unit openings 1301 through which the volatile byproducts are allowed to pass. These openings 1301 may comprise a material mesh for capturing and containing the volatile byproducts, which increase the active surface area for volatile byproducts to condensate onto, such that they remain captured and contained.

To further exemplify this material mesh may even be made from a material chosen from a list but not limited to stainless steel, copper, Monel, non-stainless steel, titanium, PP, PE, PVC, PTFE, or FEP, which could be a thermally conductive material, such that the volatile byproducts are more likely to condensate onto it, since the heat keeping the byproduct volatile is dissipated rapidly.

It may also be understood that the number of filter unit openings 1301 is arbitrary and depends on the size of the filter unit 1300 and the size of the housing 1100 of the heater track apparatus 1000, and the distance between the openings 1301. Furthermore, these openings may be arranged in a grid like manner, such as being cubical, hexagonal, triangular etc. The person skilled in the art may also understand that the openings 1301 do not have be circular, but could have any shape or form. They even may be slit-like openings along the entire length of the filter unit 1300.

In another example, the filter unit 1300 may even not comprise any filter unit openings 1301 at all. For example, multiple layers of mesh material, packed back-to-back, could also be positioned inside the housing 1100 of the heater track apparatus 1000 to capture any unwanted volatile byproducts.

Lastly, the exemplary heater track apparatus 1000 of Figure 7 and Figure 8 further comprises an air flow generating unit 1400 structured to generate an airflow through the housing. In particular it is shown in Figure 7 that the airflow is parallel to the process path.

The air flow that is being generated by the air flow generating unit 1400 ensures that the heater track apparatus 1000 remains cool where the filter unit 1300 is positioned. This ensures that condensation of the unwanted byproducts is more likely to occur, such that the removal can be more efficient.

Such air flow generating unit 1400 may even induce a flow in the housing, that drives the volatile byproducts away from the reel-to-reel lead frame tape towards the filter unit.

For example, in Figure 7 and 8, the airflow generated from the airflow generating unit inlet 1401 towards the airflow generating unit outlet 1402 could be achieved with two simple fans, which create a Venturi or Bernoulli effect creating a low pressure inside the housing 1100. This would cause any volatile gaseous substances, for instance unwanted byproducts, to flow towards the air flow generating unit 1400. Since the filter unit 1300 is conveniently positioned in between the airflow generating unit 1400 in Figure 7, the unwanted volatile byproducts would interact (condensate and remain) with the filter unit 1300 first, before being ejected out of the housing 1100 through the airflow generating unit outlet 1402.

Figure 8 depicts a cross-section of the heater track apparatus 1000. Herein, the heating unit 1200, the filter unit 1300 and the airflow generating unit 1400 can be identified as discussed in the previous paragraphs. It should be highlighted that in this example, it is clear to see that the filter unit 1300 is positioned in between the heating unit 1200 and the airflow generating unit 1400, such that the unwanted volatile byproducts are sucked through the filter unit openings 1301, capturing and containing them.

The heater track apparatus 1000 as shown in the example of Figure 8 may further even comprise a carrier gas injection unit 1500 adapted to inject a carrier gas into the housing 1100. The injected carrier gas can have twofold benefits for the heater track apparatus 1000. First, it may induce a flow for the volatile byproducts to move from the reel-to-reel lead frame tape 1 to the filter unit 1300 as an alternative to or in addition to the flow generated by the airflow generating unit 1400. Secondly, the carrier gas may be chosen to be a gas which can dissolve the volatile byproducts in large quantities, and which can drive the desorption off of the surfaces. This way, the volatile byproducts may be transported more effectively. For example as a gas, a combination of N₂/H₂, may be used.

The skilled person in the art may also understand that if the influx of the carrier gas is not high enough, no adequate flow will be induced. However, it could still overpressurize the housing 1100 such that naturally a flow will be generated to drive the carrier gas out of the housing 1100. Furthermore, in combination with an airflow generating unit 1400 creating a Venturi or Bernoulli effect, the overpressurized carrier gas in the housing 1100 is directed through the filter unit 1300 out of the housing 1100 of the heater track apparatus 1000.

The heater track apparatus 1000 as described from the figures has the benefit that it can clean the anti-tarnish layer 2 off of a reel-to-reel lead frame tape 1, while being accommodated in a semiconductor package assembly line 100₁-100₂. Thereby chances of contamination of sensitive components due to the undesired release of volatile byproducts of the heated anti-tarnish layer 2 are reduced, while keeping the high throughput of the semiconductor package assembly line 100₁-100₂ intact. Furthermore, by removing the anti-tarnish layer 2 inline the reel-to-reel lead frame tape 1 is only exposed to corrosive air for a short amount of time. All in all, this reduces errors and downtime of the process stations 5 of the semiconductor package assembly line 100₁-100₂, and increases the quality and the yield of the semiconductor packages.

### LIST OF REFERENCE NUMERALS USED

- 1: reel-to-reel lead frame tape
- 1a: unprocessed lead frame tape
- 1b: processed lead frame tape
- 2: anti-tarnish layer
- 3: reel roller
- 5: process station
- 10: prior art semiconductor package assembly line
- 11: semiconductor package assembly line inlet
- 12: semiconductor package assembly line outlet
- 20: feed roller of reel-to-reel lead frame tape
- 20a-20b-20c: supply roller
- 100₁-100₂: semiconductor package assembly line according to the disclosure
- 101: semiconductor package assembly line inlet
- 102: semiconductor package assembly line outlet
- 1000: heater track apparatus
- 1100: housing
- 1101: housing inlet
- 1102: housing outlet
- 1200: heating unit
- 1201: heating unit inlet
- 1202: heating unit outlet
- 1205: heating element
- 1206: elongated heating body
- 1207: heater cover
- 1300: filter unit
- 1301: opening for filter mesh
- 1400: air flow generating unit
- 1401: air flow generating unit inlet
- 1402: air flow generating unit outlet
- 1500: carrier gas injection unit

## Claims

1. A heater track apparatus structured to be accommodated in a reel-to-reel lead frame tape semiconductor package assembly line, the heater track apparatus adapted to receive a reel-to-reel lead frame tape provided with an anti-tarnish layer, the heater track apparatus comprising:
a housing having a housing inlet and a housing outlet defining a process path line for the reel-to-reel lead frame tape;
a heating unit positioned within the housing next to the process path line structured to generate and emit heat towards the process path line.

2. The heater track apparatus according to claim 1, wherein the heating unit comprises a heating element.

3. The heater track apparatus according to claim 2, wherein the heating unit further comprises an elongated thermally conductive heater track body positioned parallel to the process path line and positioned between the heating element and the process path line.

4. The heater track apparatus according to any one of the claims 2 or 3, wherein the heating unit further comprises a heater cover element positioned parallel to the process path positioned at an opposite location of the process path line with respect to the heating element.

5. The heater track apparatus according to any one of the claims 2-4, wherein the heating element is configured as a ceramic heating element.

6. The heater track apparatus according to any of the previous claims, wherein the heating unit is structured to generate heat in the housing to at least a temperature of 100 °C, but more preferably 200 °C, and even more preferably 300 °C.

7. The heater track apparatus according to any one of the previous claims, further comprising a filter unit structured - during use - to remove any volatile byproduct of the anti-tarnish layer from the housing.

8. The heater track apparatus according to claim 7, wherein the filter unit comprises a material mesh for capturing and containing the volatile byproducts.

9. The heater track apparatus according to any one of the claims 7 or 8, wherein the material mesh is made from a material chosen from a list but not limited to stainless steel, copper, Monel, non-stainless steel, titanium, PP, PE, PVC, PTFE, or FEP.

10. The heater track apparatus according to any one of the claims 7-9, wherein the housing is provided with at least one outlet opening and wherein the filter unit is positioned near or in the at least one airflow outlet opening.

11. The heater track apparatus according to any of the previous claims, further comprising an air flow generating unit structured to generate an airflow through the housing.

12. The heater track apparatus according to any one of the claims 7-11, wherein the filter unit is positioned between the process path and the air flow generating unit.

13. The heater track apparatus according to any of the previous claims, further comprising a carrier gas injection unit adapted to inject a carrier gas into the housing.

14. A semiconductor package assembly line adapted to process a reel to reel lead frame tape, the semiconductor package assembly line comprising a plurality of process stations defining an assembly line path having a main assembly line inlet and a main assembly line outlet for the reel-to-reel lead frame tape, further comprising a heater track apparatus according to any of the previous claims.

15. The semiconductor package assembly line according to claim 14, wherein the housing outlet of the heater track apparatus communicates with the main assembly line inlet of the semiconductor package assembly line.
